# EUROPÄISCHE PATENTSCHRIFT

(11) **EP 1 399 978 B1**
(45) Veröffentlichungstag und Bekanntmachung des Hinweises auf die Patenterteilung: **24.06.2015**
(21) Anmeldenummer: 02782430.9
(22) Anmeldetag: 25.04.2002
(51) Int. Cl.: H01L 33/50, H01L 33/56, H01L 33/54, H01L 33/62

(54) **OBERFLÄCHENMONTIERBARES STRAHLUNGSEMITTIERENDES BAUELEMENT**
SURFACE-MOUNTABLE RADIATION-EMITTING DEVICE
DISPOSITIF EMETTANT UN RAYONNEMENT POUVANT ETRE MONTE EN SURFACE

(30) Priorität: 29.06.2001 DE 10131698
(43) Veröffentlichungstag der Anmeldung: 24.03.2004
(73) Patentinhaber: OSRAM Opto Semiconductors GmbH, 93055 Regensburg (DE)
(72) Erfinder: BRUNNER, Herbert, 93049 Regensburg (DE); HÖHN, Klaus, 82024 Taufkirchen (DE); JÄGER, Harald, 93049 Regensburg (DE); SCHMID, Josef, 93049 Regensburg (DE); Brunner Reinhold, 93199 Zell, (DE)
(74) Vertreter: Epping - Hermann - Fischer
(86) Internationale Anmeldenummer: PCT/DE2002/001514
(87) Internationale Veröffentlichungsnummer: WO 2003/005458

(56) Entgegenhaltungen:
- EP-A- 0 400 175
- EP-A- 0 646 971
- WO-A-01/50540
- WO-A-98/12757
- DE-A- 19 649 650
- JP-A- H08 288 555
- JP-U- S62 140 758
- US-A- 5 682 066
- US-A- 5 942 770
- PATENT ABSTRACTS OF JAPAN vol. 1995, no. 10, 30. November 1995 (1995-11-30) -& JP 07 169893 A (ROHM CO LTD), 4. Juli 1995 (1995-07-04)
- PATENT ABSTRACTS OF JAPAN vol. 007, no. 013 (E-153), 19. Januar 1983 (1983-01-19) & JP 57 169281 A (MITSUBISHI DENKI KK), 18. Oktober 1982 (1982-10-18)
- PATENT ABSTRACTS OF JAPAN vol. 018, no. 556 (E-1620), 24. Oktober 1994 (1994-10-24) -& JP 06 204569 A (CASIO COMPUT CO), 22. Juli 1994 (1994-07-22)
- PATENT ABSTRACTS OF JAPAN vol. 018, no. 313 (C-1212), 15. Juni 1994 (1994-06-15) -& JP 06 065473 A (DENKI KAGAKU KOGYO), 8. März 1994 (1994-03-08)

## Beschreibung

Die Erfindung betrifft ein oberflächenmontierbares strahlungsemittierendes Bauelement.

In der Offenlegungsschrift DE 38 04 293 A1 ist eine Weißlichtquelle auf der Basis einer, Halbleiter-LED bekannt. Darin ist eine Anordnung mit einer Elektrolumineszenz oder Laserdiode beschrieben, bei der das von der Diode abgestrahlte Emissionsspektrum mittels eines mit einem phosphoreszierenden, lichtwandelnden organischen Farbstoff versetzten Elements aus Kunststoff zu größeren Wellenlängen hin verschoben wird. Das von der Anordnung abgestrahlte Licht weist dadurch eine andere Farbe auf als das von der Leuchtdiode ausgesandte Licht. Abhängig von der Art des im Kunststoff beigefügten Farbstoffes lassen sich mit ein und demselben Leuchtdiodentyp Leuchtdiodenanordnungen herstellen, die in unterschiedlichen Farbe leuchten.

In der WO 98/12757 A1 ist eine wellenlängenkonvertierende Vergußmasse für ein elektrolumineszierendes Bauelement mit einem ultraviolettes, blaues, oder grünes Licht aussendenden Körper auf der Basis eines transparenten Epoxidharzes beschrieben, das mit einem Leuchtstoff, insbesondere mit einem anorganischen Leuchtstoffpigmentpulver mit Leuchtstoffpigmenten aus der Gruppe der Phosphore, versetzt ist. Als bevorzugtes Ausführungsbeispiel wird eine Weißlichtquelle beschrieben, bei welcher eine strahlungsemittierende Halbleiter-LED auf der Basis von GaAlN mit einem Emissionsmaximum zwischen 420 nm und 460 nm zusammen mit einem Leuchtstoff verwendet wird, der so gewählt ist, daß eine von dem Halbleiterkörper ausgesandte blaue Strahlung in komplementäre Wellenlängenbereiche, insbesondere blau und gelb, oder zu additiven Farbtripeln, z.B. blau, grün und rot, umgewandelt wird. Hierbei wird das gelbe bzw. das grüne und das rote Licht von den Leuchtstoffen erzeugt. Der Farbton (Farbort in der CIE-Farbtafel) des solchermaßen erzeugten weißen Lichts kann dabei durch geeignete Wahl des oder der Leuchtstoffe hinsichtlich Mischung und Konzentration variiert werden.

Ebenso offenbart die WO 98/54929 A2 ein sichtbares Licht emittierendes Halbleiterbauelement mit einer UV-/blau-LED, welche in einer Vertiefung eines Trägerkörpers angeordnet ist, deren Oberfläche eine lichtreflektierende Schicht aufweist und mit einem transparenten Material gefüllt ist, welches die LED an ihren Lichtaustrittsseiten umgibt. Zur Verbesserung der Lichtauskopplung weist das transparente Material einen Brechungsindex auf, der niedriger als der Brechungsindex der lichtaktiven Region der LED ist.

Bei diesen vorbekannten Bauformen wird zunächst ein vorgehäustes Bauteil dadurch hergestellt, daß ein vorgefertigter Leiterrahmen (Leadframe) mit einem geeigneten Kunststoffmaterial umspritzt wird, welches das Gehäuse des Bauteils bildet. Dieses Bauteil weist an der Oberseite eine Vertiefung auf, in die von zwei gegenüberliegenden Seiten Leadframeanschlüsse eingeführt sind, auf dessen einem eine Halbleiter-LED aufgeklebt und elektrisch kontaktiert wird. In diese Vertiefung wird dann eine mit dem Leuchtstoff versetzte Vergußmasse, in der Regel ein transparentes Epoxidharz eingefüllt.

Der Vorteil dieser bekannten Bauformen liegt darin, daß eine sehr gerichtete Abstrahlung dadurch erreicht werden kann, indem die durch das Kunststoffgehäuse gebildeten Seitenwände als schräggestellte Reflektoren ausgebildet werden können. In den Anwendungsfällen, in denen jedoch eine derart gerichtete Abstrahlung nicht unbedingt erforderlich ist oder auf andere Weise erzielbar ist, stellt sich das Herstellungsverfahren als relativ aufwendig und mehrstufig dar, da der Gehäusekunststoff und die Vergußmasse aus zwei verschiedenen Materialien gebildet werden und in getrennten Verfahrensschritten angeformt werden müssen. Zudem muß stets das Problem einer ausreichenden und temperaturstabilen Haftung zwischen der Vergußmasse und dem Gehäusekunststoff gelöst werden. In der Praxis führt dies insbesondere bei Verwendung hoher Lichtleistungen immer wieder zu Problemen.

In vielen potentiellen Anwendungsgebieten für Leuchtdioden wie z.B. bei Anzeigeelementen im Kfz-Armaturenbereich, Beleuchtung in Flugzeugen und Autos und bei vollfarbtauglichen LED-Displays, tritt verstärkt die Forderung nach Leuchtdiodenanordnungen auf, mit denen sich mischfarbiges Licht, insbesondere weißes Licht, erzeugen läßt. Dabei soll hinsichtlich der Farbe des erzeugten Lichts ein möglichst großer Bereich des Farbraumes abgedeckt werden. Oftmals werden Beleuchtungs- und Anzeigeelemente benötigt, die Licht mit einem genau vorgegebenem Farbort und einer genau vorgegebenen Farbsättigung abstrahlen.

Die Druckschrift JP 07-169893 A betrifft eine oberflächenmontierbere LED mit einer parallel zu einer Montageebene orientierten Hauptabstrahlrichtung.

Aus der Druckschrift DE 196 49 650 A1 ist ein strahlungsemittierendes Halbleiterbauelement mit einem Leiterrahmen, der aus einer Vergussmasse herausragt, bekannt.

In der Druckschrift JP 62-140758 U ist eine LED mit Löchern in einem Leiterrahmen beschrieben.

Eine LED mit einem mäanderförmigen Leiterrahmen findet sich in der Druckschrift JP 08-255555 A.

Der vorliegenden Erfindung liegt die Aufgabe zugrunde, ein verbessertes strahlungsemittierendes oberflächenmontierbares Bauelement anzugeben.

Diese Aufgabe wird durch ein Bauelement gemäß Patentanspruch 1 gelöst. Vorteilhafte Weiterbildungen der Erfindung sind Gegenstand der abhängigen Ansprüche.

Dementsprechend beschreibt die Erfindung ein oberflächenmontierbares strahlungsemittierendes Bauelement mit einem strahlungsemittierenden Chip, der auf einen Leadframe montiert ist, wobei der Leadframe und der strahlungsemittierende Chip mit einer Formmasse umhüllt sind, die derart geformt ist, daß das Bauelement eine Montagefläche aufweist, die zu einer Hauptabstrahlungsrichtung des Bauelements in einem ersten vorgegebenen Winkel angeordnet ist. Der Leadframe weist aus der Formmasse herausgeführte Leadframeanschlüsse mit Anschlußflächen auf, die in einem zweiten vorgegebenen Winkel zu der Montagefläche angeordnet sind.

Der strahlungsemittierende Chip kann ein Lichtemissiondiodenchip wie beispielsweise eine Halbleiter-LED oder ein Halbleiterlaser sein. Vorzugsweise emittiert dieser Chip elektromagnetische Strahlung im ultravioletten oder blauen Spektralbereich.

Gemäß der Erfindung sind die Hauptabstrahlrichtung und die Montagefläche parallel angeordnet, so daß der erste Winkel 0° beträgt. Das Bauelement ist als sogenannter Seitenstrahler ausgeführt, der vorwiegend parallel zu der Montagefläche bzw. im eingebauten Zustand zu einer Trägerplatte, beispielsweise einer Platine, auf der das Bauelement befestigt ist, emittiert. Eine solche Abstrahlcharakteristik ist insbesondere für eine seitliche Lichteinkopplung in ein zu beleuchtendes Display, zum Beispiel eine LCD-Anzeige, vorteilhaft und ermöglicht eine sehr flache Bauform. Der Leadframe ist dabei so angeordnet, daß die Anschlußflächen der Leadframeanschlüsse senkrecht auf der Montagefläche stehen oder in einem in etwa senkrechten Winkel zu der Montagefläche angeordnet sind, so daß der zweite vorgegebene Winkel 90° beträgt oder beispielsweise zwischen 70° und 90° liegt. Weitergehend kann der erste vorgegebene Winkel auch beispielsweise zwischen 0° und 20° liegen, so daß das Bauelement seitlich emittiert, ohne daß die Hauptabstrahlrichtung parallel zur Montagefläche ausgerichtet ist.

Ein weiterer Vorteil eines Bauelements mit einem auf einem Leadframe aufgebrachten strahlungsemittierenden Chip und einer Umhüllung mit einer Formmasse ist eine sehr kleine Bauform sowie ein sehr geringer Platzbedarf des Bauelements bei gleichzeitig guter Wärmeableitung. Damit lassen sich mit solchen Bauteilen sehr dicht gepackte Module mit einer Mehrzahl von solchen Bauelementen realisieren.

Bevorzugt ist die Formmasse auf Harzbasis, insbesondere aus einem vorreagierten Harz gebildet. Besonders bevorzugt ist die Formmasse durch Vermischen und Vermengen einer strahlungsdurchlässigen Kunststoff-Preßmasse mit einem Konversionsstoff hergestellt.

Es erstrecken sich die seitlich herausgeführten Leadframeanschlüsse bis zu der durch die Montagefläche festgelegten Montageebene oder bis in deren Nähe. Damit wird erreicht, daß eine Trägerplatte mit entsprechenden Leiterbahnstrukturen zugleich der elektrischen Versorgung des Bauelements dienen kann. Die Leadframeanschlüsse können dabei auch etwas beabstandet von der Montageebene enden. Kontaktierungen auf der Trägerplatte, beispielsweise Lötkontaktflächen, sind in der Regel leicht kuppenförmig gebildet und gleichen so den Abstand zwischen den Leadframeanschlüssen und einer Trägerplatte aus.

Vorzugsweise ist der Leadframe insgesamt eben ausgebildet. Damit wird die Herstellung vereinfacht, da keine zusätzlichen Biegungen geformt werden müssen. Zudem werden mechanische Spannungen, die durch solche Biegungen entstehen könnten, vermieden. Weiterhin stellt ein ebener Leadframe eine plane, genau definierte Montageplattform zur Aufbringung des strahlungsemittierenden Chips dar. Dies erleichtert die automatische Bestückung und Kontaktierung mit diesen Chips. Insbesondere die hierfür eingesetzten optischen Erkennungs- und Steuerungssysteme können durch nicht planparallele Montageflächen, wie sie bei vorgebogenen Leadframes beispielsweise aufgrund von Biegetoleranzen auftreten können, irritiert werden. Dies führt zu Fehlfunktionen, die bei ebenen Leadframes gemindert sind.

Es sind Durchbrüche oder seitliche Ausnehmungen in dem Leadframe vorgesehen. Diese Durchbrüche oder Ausnehmungen werden von der Kunststoff-Preßmasse ausgefüllt, wodurch sich eine mechanisch stabile Verankerung des Leadframes in der Kunststoff-Preßmasse ergibt.

Bei einer besonders bevorzugten Ausführungsform weist das Bauelement eine zur Montagefläche parallele Deckfläche auf. Dies ermöglicht die Verwendung des Bauelements bei sogenannten Pick & Place-Verfahren, vorzugsweise in Verbindung mit automatischen Bestückungsvorrichtungen. Dabei wird das Bauelement an einer Fläche von einem Saugarm angesaugt, zu seinem vorgesehenen Bestückungsort befördert und dort montiert. Dies erfordert in der Regel parallele und ebene Ansaug- und Montageflächen.

Gemäß der Erfindung ist die Umhüllung so geformt, daß das Bauelement in Abstrahlrichtung von einer gewölbten Oberfläche begrenzt ist. Damit erfüllt die Umhüllung zugleich die Funktion eines optischen Elements, beispielsweise einer Linse. Je nach Wölbung und Wölbungsrichtung kann sowohl eine Fokussierung als auch eine Aufweitung der Abstrahlcharakteristik erreicht werden.

Je nach Abstimmung des Konversionsstoffs auf die von dem strahlungsemittieren Chip erzeugte Strahlung eignet sich die Erfindung als Weißlichtquelle oder als Farblichtquelle, wobei Farbort und Farbsättigung bei Verwendung geeigneter Konversionstoffe in weiten Grenzen frei festgelegt werden können. Durch einen gewissen Anteil von Weißlicht kann bei einer Farblichequelle der optische Eindruck einer ungesättigten Emissionsfarbe hervorgerufen werden.

Die Erfindung ist jedoch nicht auf den sichtbaren optischen Spektralbereich beschränkt. Der strahlungsemittierende Chip und/oder das Konversionselement kann ebenso für eine Strahlungsemission im Ultravioletten oder Infraroten vorgesehen sein. Damit kann beispielsweise misch"farbige" infrarote oder ultraviolette Strahlung, d.h. infrarote oder ultraviolette Strahlung mit zwei oder mehr spektralen Komponenten erzeugt werden.

Hinsichtlich seiner Formgebung verzichtet das Bauelement vorteilhafterweise auf die Formung einer Vertiefung und den Einsatz zweier unterschiedlicher Materialien und sieht statt dessen die Verwendung einer einzigen transparenten Formmasse vor, die gegebenenfalls zunächst mit dem Konversionsstoff vermengt wird und.dann um den Leadframe geformt, vorzugsweise gespritzt wird. Die ausgehärtete Formmasse dient somit gleichzeitig als Bauteilgehäuse und als transparente Konversionsstoffmatrix. Dadurch wird zum einen das Herstellungsverfahren erheblich vereinfacht, da in einem einzigen Anformprozeß, insbesondere einem Spritzgußprozeß, das Gehäuse gebildet wird. Zugleich kann die Formmasse als Matrix für den Konversionsstoff dienen.

Weiterhin wird ein Bauelement hergestellt, das verbesserte Stabilitätseigenschaften aufweist, da daß Problem der Haftung zwischen zwei umhüllenden Materialien wie beispielsweise einem Gehäusegrundkörper und einem Verguß, die zudem verschiedene thermische Ausdehnungskoeffizienten aufweisen können, nicht mehr auftritt.

Es wird eine reproduzierbare und gezielte Einstellung der Farborte in engen Grenzen dadurch erreicht, daß die Sedimentation der Konversionsstoffe bei der Lagerung und Verarbeitung insbesondere durch schnelle Anhärteschritte weitestgehend ausgeschlossen wird. Die Qualität der Konversionsstoffe wird durch einfache Verfahrensschritte mit einfacheren Dosiermöglichkeiten bei der Harzaufbereitung, Mischung und Dosierung gesteigert.

Durch die Verwendung nur noch eines einzigen Materials für die Gehäuseform und die Konversionsstoffmatrix ergibt sich Spielraum für eine weitere Miniaturisierung. Dieses zusätzliche Miniaturisierungspotential kann für die Anwendung dieser Bauelemente in mobilen elektronischen Produktsystemen, beispielsweise als Weißlichtquelle, genutzt werden. Erhöhte Lichtausbeuten durch verstärktes Ausnutzen der Seitenstrahlung in speziellen Einbausituationen mit weiteren Gestaltungsfreiheitsgraden oder reine Seitenlichtauskopplungsmöglichkeiten erweitern die Funktionalität.

Die Kunststoff-Preßmasse kann als Ausgangsmaterial eine kommerziell erhältliche Preßmasse sein und besteht beispielsweise im wesentlichen aus einem Epoxykresolnovolak oder gängigen Epoxidharzsystemen mit einem Anhydrid- oder einem üblichen Phenolhärter-System.

Der in der Kunststoff-Preßmasse dispergierte Konversionsstoff kann ein anorganisches Leuchtstoffpigmentpulver sein, das Leuchtstoffe mit der allgemeinen Formel A₃B₅X₁₂ : M enthält. Insbesondere können als Leuchtstoffpigmente Partikel aus der Gruppe der Ce-dotierten Granate verwendet werden, wobei insbesondere Ce-dotiertes Yttriumaluminiumgranat (Y₃Al₅O₁₂:Ce) zu nennen ist. Weitere mögliche Leuchtstoffe sind Wirtsgitter auf Sulfid- und Oxysulfidbasis, Aluminate, Borate, etc. mit entsprechend im kurzwelligen Bereich anregbaren Metallzentren. Auch metallorganische Leuchtstoffsysteme sind verwendbar. Die Leuchtstoffpigmente können dabei auch eine Mehrzahl verschiedener Leuchtstoffe und der Konversionsstoff kann eine Mehrzahl verschiedener Leuchtstoffpigmente enthalten.

Der Leuchtstoff kann ebenso durch lösliche und schwer lösliche organische Farbstoffe und Leuchtstoffabmischungen gebildet werden.

Weiterhin kann dem vorzugsweise vorgetrockneten Konversionsstoff ein Haftvermittler vorzugsweise in flüssiger Form beigemengt werden, um die Haftfähigkeit des Konversionsstoffes mit der Kunststoff-Preßmasse zu verbessern. Insbesondere bei der Verwendung von anorganischen Leuchtstoffpigmenten kann als Haftvermittler 3-Glycidoxypropyltrimethoxysilan oder weitere Derivate auf Trialkoxysilan-Basis verwendet werden.

Zur Modifizierung der Leuchtstoffoberflächen können einfach-und mehrfachfunktionelle polare Agentien mit Carbonsäure-, Carbonsäureester-, Ether- und Alkoholgruppen, wie beispielsweise Diethylenglykolmonomethylether eingesetzt werden. Damit wird die Benetzbarkeit der hochenergetischen Leuchtstoffoberflächen und damit die Verträglichkeit und Dispergierung bei der Verarbeitung mit der Formmasse verbessert.

Weiterhin kann der Kunststoff-Preßmasse vor dem Vermengen mit dem Konversionsstoff ein Entformungs- oder Trennmittel beigemengt werden. Derartige Entformungsmittel erleichtern das Herauslösen der ausgehärteten Formmasse aus der Gußform. Als derartiges Entformungsmittel kann ein festes Entformungsmittel auf Wachsbasis oder eine Metallseife mit langkettigen Carbonsäuren, insbesondere Stearaten verwendet werden.

Als weitere Füllstoffe können beispielsweise anorganische Füllstoffe beigemengt werden, durch die der Brechungsindex der Formmasse gesteigert werden kann, wodurch die Lichtausbeute des Bauelements erhöht werden kann. Als derartige Füllstoffe können beispielsweise TiO₂, ZrO₂, α-Al₂O₃ oder andere Metalloxid eingesetzt werden.

Gemäß der Erfindung sind der Formmasse als Füllstoff Glaspartikel, sog. Glasfilier, zugesetzt. Dadurch wird die Glasübergangstemperatur T_{G} der Formmasse erhöht. Die Glasübergangstemperatur der Formmasse begrenzt den für das Bauelement zulässigen Temperaturbereich, da eine Überschreitung der Glasübergangstemperatur zu einem Fließen der Formmasse und in Folge zu Spannungen und Defekten an dem strahlungsemittierenden Chip sowie daran angebrachten Drahtverbindungen führen kann. Die Zugabe von Glaspartikeln zur Formmasse erhöht mit Vorteil den für das Bauelement zulässigen Temperaturbereich. Weitergehend kann das Bauelement mit einem höheren Betriebsstrom betrieben und mehr Strahlung erzeugt werden. Ein weiterer Vorteil besteht in einer Reduzierung des thermischen Ausdehnungskoeffizienten der Formmasse, der damit besser an den thermischen Ausdehnungskoeffizienten des Leadframes angepaßt ist, so daß die Temperaturbeständigkeit des Bauelements weiter erhöht wird.

Durch die Zugabe von Glaspartikeln wird ferner auch der Brechungsindex der Formmasse erhöht, so daß der Brechungsindexsprung zwischen dem strahlungsemittierenden Chip und der Formmasse geringer und vorteilhafterweise die Strahlungsauskopplung größer wird.

Schließlich wird durch die Zugabe von Glaspartikeln die Wasseraufnahme der Formmasse herabgesetzt. Dies führt mit Vorteil zu einer verbesserten thermischen Belastbarkeit des Bauelements. Insbesondere wird die Gefahr einer Beschädigung oder eines Aufplatzens des Bauelements beim Einlöten aufgrund eines zu hohen Wassergehalts (sogenannter Popcorn-Effekt) vorteilhafterweise reduziert.

Die mittlere Korngröße der Glaspartikel liegt unter 50 µm. Damit wird unter anderem die Gefahr einer Verstopfung der oftmals engen Zuführungskanäle einer Spritzgußform reduziert.

Der Anteil der Glaspartikel an der Formmasse kann 90 Gew.-% oder mehr betragen und liegt vorzugsweise zwischen 10 Gew.-% und 50 Gew.-%. In dem letzgenannten Bereich zeichnet sich die Formmmase sowohl durch eine hohe Transparenz als auch durch eine hohe Glasübergangstemperatur aus.

Bevorzugterweise werden der Konversionsstoff und gegebenenfalls die weiteren Füllstoffe dadurch vermengt, indem sie zunächst grob gemischt werden und dann das Gemisch in einer Mühle gemahlen wird, wodurch ein sehr feines, homogenes Pulver gewonnen wird.

Die vermengte Formmasse kann somit die folgenden Bestandteile (in Gew.-%) enthalten:
a) Kunststoff-Preßmasse ≥ 60%
b) Konversionsstoff > 0 und ≤ 40%
c) Haftvermittler ≥ und ≤ 3%
d) Entformungsmittel ≥ 0 und ≤ 2%
e) Oberflächenmodifikator ≥ 0 und ≤ 5%
f) Oxidationsstabilisator ≥ 0 und ≤ 5%
   (z.B. auf Phosphitbasis oder auf Basis sterisch gehinderter Phenole)
g) UV-Lichtstabilisator ≥ 0 und ≤ 2%
h) Glaspartikel > 0 und ≤ 80%.

Weitere Merkmale, Vorzüge und Zweckmäßigkeiten der Erfindung werden nachfolgend anhand der Figuren 1 bis 4 erläutert.

Es zeigen:
Figur 1 eine schematische Schnittansicht einer Abwandlung eines Bauelements,
Figur 2 eine schematische Schnittansicht eines Ausführungsbeispiels eines erfindungsgemäßen Bauelements
Figur 3 eine schematische perspektivische Ansicht einer Abwandlung eines Bauelements und
Figur 4 eine schematische perspektivische Ansicht einer Abwandlung eines Bauelements.

Gleiche oder gleichwirkende Elemente sind in den Figuren mit denselben Bezugszeichen versehen.

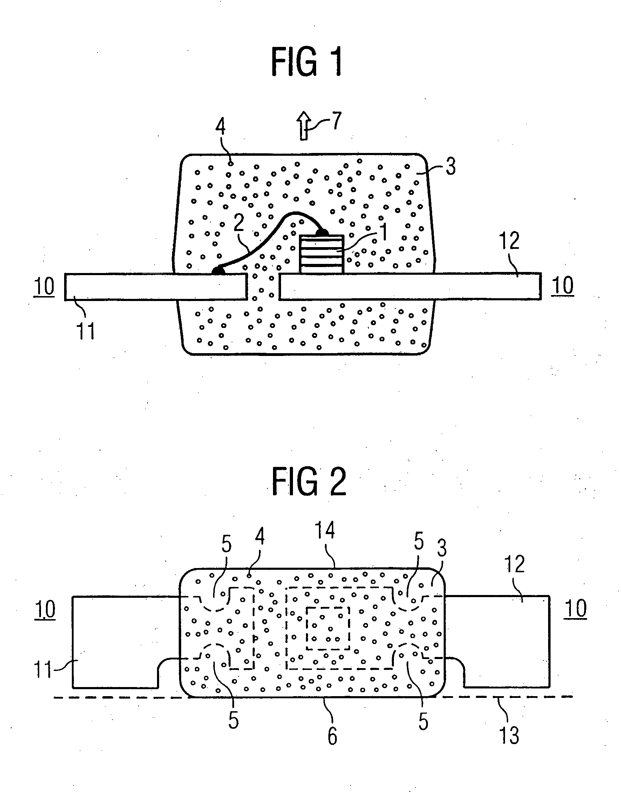

In Figur 1 ist eine Abwandlung eines Bauelements in einem Querschnitt entlang einer Längsachse eines Leadframes 10 dargestellt.

In einem ursprünglich einstückigen und zusammenhängenden Leadframe 10 sind zwei Leadframeanschlüsse 11 und 12 ausgebildet, die in an sich bekannter Weise anfänglich noch durch schmale Verbindungsstege zusammengehalten werden, jedoch im Laufe des Herstellungsverfahrens durch Auftrennen dieser Verbindungsstege voneinander isoliert werden.

Auf einem Leadframeanschluß 12 ist auf dessen innenseitigem Endabschnitt eine fertigprozessierte Halbleiter-LED 1 mit einem elektrisch leitenden Verbindungsmittel wie Leitsilber oder dergleichen aufgeklebt oder aufgelötet, so daß die n- oder p-Seite der Halbleiter-LED 1 mit dem Leadframeanschluß 12 verbunden ist. Die gegenüberliegende p- oder n- leitende Kontaktseite ist durch einen Bonddraht 2 mit dem Endabschnitt des anderen Leadframeanschlusses 11 verbunden.

Das Bauelement ist von einer Kunststoff-Preßmasse 3 umhüllt, in die bevorzugt ein Konversionsstoff 4 in Form von Leuchtstoff-partikeln eingebracht sein kann. Dies wird im folgenden noch genauer ausgeführt.

Die Montagefläche liegt bei dem gezeigten Bauelement parallel zur Schnittebene. Der Leadframe 10 ist durchgehend eben ausgebildet und steht näherungsweise senkrecht auf der Montagefläche, so daß der zweite vorgegebene Winkel im Rahmen der Fertigungstoleranzen etwa 90° beträgt.

Diese Gestaltung ermöglicht sowohl eine kostengünstige Fertigung des Leadframes, beispielsweise durch Ausstanzen aus einem Blech oder einer Folie ohne zusätzliche Biegungen, als auch einen sehr geringen Platzbedarf des Bauelements. Die Abstrahlung erfolgt vorwiegend senkrecht zu dem Leadframe 10, so daß die Hauptabstrahlungsrichtung 7 näherungsweise parallel zu der Montagefläche ist und der erste vorgegebene Winkel beträgt im Rahmen der Fertigungstoleranzen 0° beträgt.

In Figur 2 ist eine schematische Schnittansicht eines Ausführungsbeispiels eines erfindungsgemäßen Bauelements gezeigt. Die Schnittebene verläuft wiederum entlang einer Längsachse des Leadframes 10 und ist senkrecht zu der in Figur 1 gewählten Schnittebene orientiert.

Hierbei weist der Leadframe 10 seitliche Ausnehmungen 5 auf. Diese Ausnehmungen 5 sind mit der umhüllenden Kunststoff-Preßmasse gefüllt, so daß dadurch eine Art Verzahnung zwischen dem Leadframe 10 und der Umhüllung entsteht, die eine mechanisch stabile Verankerung des Leadframes in der Umhüllung gewährleistet. Zu diesem Zweck könnten auch Durchbrüche in dem Leadframe 10 gebildet sein (nicht dargestellt).

Die Leadframeanschlüsse 11,12 ragen in einer Haupterstrekkungsrichtung der durch die Montagefläche 6 festgelegten Montageebene 13 aus der Umhüllung des Bauelements heraus und erstrecken sich beabstandet von der Umhüllung in Richtung der Montageebene 13. Zwischen der Montageebene 13 und den Lead-frameanschlüssen 11,12 ist ein kleiner Spalt gebildet, der bei der Kontaktierung, beispielsweise durch Lötkontakte, überbrückt wird. Vorteilhafterweise wird so die Auflage des Bauelements allein durch die Montagefläche 6 festgelegt, wodurch mechanische Spannungen zwischen Leadframe 10 und Umhüllung vermieden werden. Weiterhin wird durch die leichte Beabstandung der Leadframeanschlüsse 11,12 von der Montageebene 13 die Gefahr vermindert, daß Leadframeanschlüsse 11,12, die, beispielsweise aufgrund von Fertigungstoleranzen bei der Einkapselung mit Formmasse, über die Montageebene 13 hinausragen, zu einer Verbiegung der Leadframeanschlüsse 11,12 oder einer Verkippung des Bauelements bei der Montage führen.

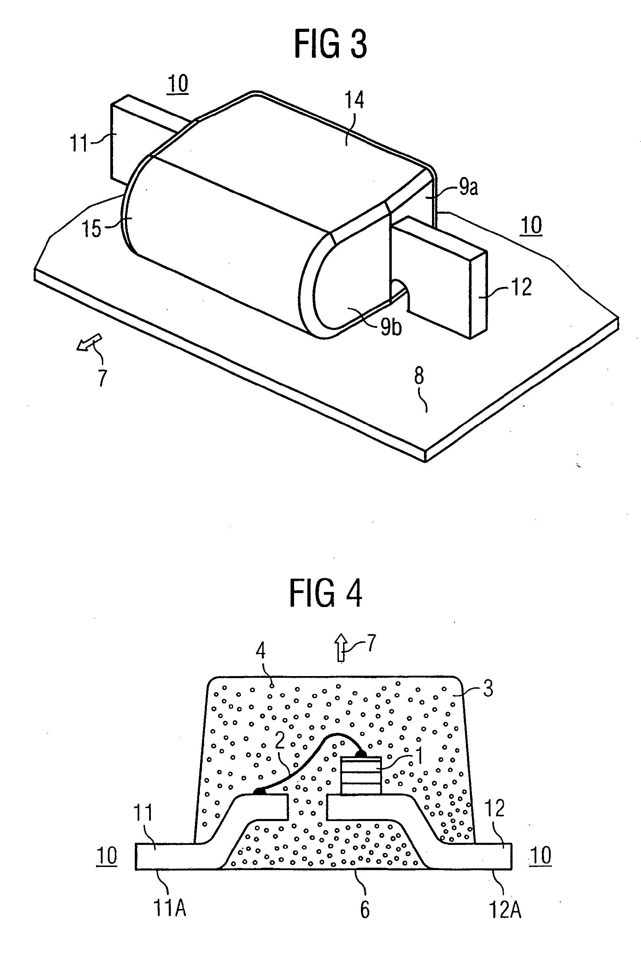

In Figur 3 ist perspektivisch eine Abwandlung eines Bauelements auf einem Träger 8, beispielsweise einer Platine, dargestellt. Die Abstrahlung erfolgt im wesentlichen parallel zu der Trägerhauptfläche, auf der das Bauelement mit der Montagefläche 6 aufliegt. Seitens der Leadframeanschlüsse ist das Bauelement durch gegeneinander verkippte Schrägflächen 9a, 9b begrenzt, die als sogenannte Entformungsschrägen das Abtrennen eines Formwerkszeugs von dem Bauelementkörper bei der Herstellung erleichtern.

In Abstrahlungsrichtung 7 ist das Bauelement von einer gewölbten, im dargestellten Fall teilzylindrischen Oberfläche 15 begrenzt, wobei die Zylinderachse näherungsweise parallel zur Längsachse des Leadframes angeordnet ist. Die gewölbte Oberfläche kann auch sphärisch als Teil einer Kugeloberfläche oder asphärisch gebildet sein. Ferner ist sowohl eine konvex als auch eine konkav gewölbte Oberfläche möglich.

Durch diese Formgebung wird eine Linsenwirkung und damit eine Bündelung der emittierten Strahlung erreicht.

Die Halbleiter-LED 1 weist ein Emissionsspektrum auf, das im ultravioletten oder blauen Spektralbereich liegt. Für die Erzeugung von mischfarbigem oder weißem Licht ist eine Emission der Halbleiter-LED im ultravioletten oder blauen Spektralbereich besonders vorteilhaft, da eine Konversion zu längeren Wellenlängen in der Regel wesentlich effizienter ist als zu kürzeren Wellenlängen. Da der ultraviolette oder blaue Spektralbereich am kurzwelligen Ende des optisch sichtbaren Bereichs liegt, ist von dort aus mittels geeigneter Konversionsstoffe eine effiziente Konversion zu einem Großteil der sichtbaren Wellenlängen möglich.

Vorzugsweise ist die Halbleiter-LED 1 auf der Basis von GaN, InGaN, AlGaN oder AlInGaN aufgebaut. Sie kann jedoch alternativ auch auf dem Materialsystem ZnS/ZnSe oder auf einem anderen für diesen Spektralbereich geeigneten Materialsystem basieren.

Die in Figur 4 gezeigte Abwandlung eines Bauelements ist im Gegensatz zu den bisher beschriebenen Bauelementen mit einer senkrecht zur Montageebene 6 angeordneten Hauptabstrahlungsrichtung 7 ausgeführt. Der erste vorgegebene Winkel beträgt hier etwa 90°. Der Leadframe 10 weist zwei S-fömige Biegungen auf, wobei die Leadframeanschlüsse seitlich aus der Formmasse 3 herausragen und die Anschlußflächen der Leadframenschlüsse in der durch die Montagefläche 6 festgelegten Montageebene 13 liegen. Der zweite vorgegebene Winkel beträgt hier also 0°.

Auf einem Teil des zweiteiligen Leadframes 10 ist ein strahlungsemittierender Chip 1 in Form einer Halbleiter-LED befestigt, beispielsweise aufgelötet oder elektrisch leitend aufgeklebt. Zu dem anderen Teil des Leadframes ist eine Drahtverbindung 2 geführt. Leadframe 10 und Halbleiter-LED sind wie bei den anderen Ausführungsbeispielen von einer strahlungsdurchlässigen Formmasse mit Konversionsstoff umhüllt.

Bei einem Ausführungsbeispiel eines erfindungsgemäßen Herstellungsverfahrens wird nach dem Aufbringen und Kontaktieren der Halbleiter-LED 1 in einer geeigneten Spritzgußapparatur eine transparente Kunststoff-Preßmasse 3 an die Leadframeanschlüsse 11 und 12 angespritzt.

Bevorzugt wird der Leadframe mit Halbleiter-LED mittels eines Spritzguß- oder Spritzpreßgußverfahrens mit der Kunststoff-Preßmasse umformt. Dazu wird ein Teilbereich des Leadframes 10 mit vormontierter Halbleiter-LED 1 in eine Spritzform eingebracht werden, die Kunststoff-Preßmasse 3 verflüssigt und in die Spritzform eingespritzt. Dabei ist es vorteilhaft, den Leadframe (10) vor dem Umspritzen vorzuwärmen.

Bei einer Variante dieses Verfahrens kann auch eine Mehrzahl von Leadframes mit jeweils darauf montierten strahlungsemittierenden Chips in eine zusammenhängende Umhüllung eingekapselt werden und nachfolgend, beispielsweise durch Brechen, Sägen, ein Lasertrennverfahren oder mittels eines Wasserstrahls, in einzelne Bauelemente zerteilt werden.

In diese Kunststoff-Preßmasse 3 sind als Konversionsstoff 4 Leuchtstoffpartikel eingebettet, die aus einem Leuchtstoff bestehen, mit dem eine mindestens teilweise Wellenlängenkonversion der von der Halbleiter-LED 1 emittierten Lichtstrahlung herbeigeführt wird. Durch diese Wellenlängenkonversion wird ein Emissionsspektrum erzeugt, daß den optischen Eindruck von mischfarbigem Licht oder von Weißlicht hervorruft.

Die Vorfertigung des Leadframes 10 und die Umspritzung durch die aus der Kunststoff-Preßmasse 3, den Leuchtstoffpartikeln 4 und gegebenenfalls weiteren Füllstoffen bestehende Formmasse erfolgt derart, daß die Leadframeabschnitte 11 und 12 horizontal aus der Formmasse herausgeführt werden.

Das fertige Bauteil kann mit den auf der Montagefläche senkrecht stehenden Anschlußflächen der Leadframeanschlüsse 11 und 12 auf eine Platine gelötet werden. Dadurch wird ein für die SMT-(Surface Mounting Technology) Montage geeignetes Bauelement hergestellt.

Die Herstellung der durch die Kunststoff-Preßmasse 3, die Leuchtstoffpartikel 4 und gegebenenfalls weitere Füllstoffe gebildeten Formmasse wird nachfolgend genauer beschrieben.

Als Ausgangsstoffe für die Kunststoff-Preßmasse können vorreagierte, lager- und strahlungsstabile transparente Preßmassen aus handelsüblichen Epoxykresolnovolaken mit phenolischen Härtern verwendet werden, deren Gesamtchlorgehalt unterhalb 1500 ppm liegt. Vorzugsweise enthalten diese Preßmassen ein internes Entformungs- oder Trennmittel, durch welches das Herauslösen der ausgehärteten Formmasse aus der Spritzgußform erleichtert wird. Das Vorhandensein eines derartigen internen Entformungsmittels stellt jedoch keine zwingende Notwendigkeit dar. Es können beispielsweise somit die folgenden kommerziell erhältlichen Preßmassen der Firmen Nitto und Sumitomo verwendet werden:
Nitto NT-600 (ohne internes Entformungsmittel)
Nitto NT-300H-10.000 (mit internem Entformungsmittel)
Nitto NT.300S-10.000 (mit internem Entformungsmittel)
Nitto NT 360- 10.000 (mit internem Entformungsmittel)
Sumitomo EME 700L (ohne internes Entformungsmittel)

Diese Preßmassen werden standardmäßig in Stab- oder Tablettenform geliefert.

Die Verwendung von Preßmassen in Stab- oder Tablettenform erleichtert gegenüber einer in Pulverform vorliegenden Preßmasse die Dosierung und erhöht deren Genauigkeit. Selbstverständlich kann aber bei der Erfindung auch eine als Pulver oder in einer anderen Modifikation vorliegende Preßmasse verwendet werden. Weitergehend könnte auch eine als Pulver vorliegende Preßmasse zunächst zur genaueren Dosierung in Stab- oder Tablettenform gebracht und dann weiterverarbeitet werden.

Als Konversionsstoffe kann sämtliche Leuchtstoffe enthalten, die in den bereits genannten Druckschriften WO 97/ 50132 und WO 98/12757 beschrieben sind. Insbesondere kann ein anorganisches Leuchtstoffpigmentpulver mit Leuchtstoffen mit der allgemeinen Formel A₃B₅X₁₂ : M verwendet werden. Dies sind bespielsweise mit Seltenen Erden, insbesondere Ce, dotierte Granate.

Als effiziente Leuchtstoffe haben sich Verbindungen erwiesen, die der Formel A'₃B'₅O₁₂:M' genügen (sofern sie nicht unter den üblichen Herstellungs- und Betriebsbedingungen instabil sind). Darin bezeichnet A' mindestens ein Element der Gruppe Y, Lu, Sc, La, Gd, Tb und Sm, B' mindestens ein Element der Gruppe Al, Ga und In und M_{'} mindestens ein Element der Gruppe Ce und Pr, vorzugsweise Ce. Als besonders effiziente Leuchtstoffe haben sich die Verbindungen YAG:Ce (Y₃Al₅O₁₂:Ce), TAG:Ce (Tb₃Al₅O₁₂:Ce), TbYAG:Ce ((TbₓY₁₋ₓ)₃Al₅O₁₂ : Ce, 0≤x≤1), GdYAG: Ce ((GdₓY₁₋ₓ)₃Al₅O₁₂ : Ce³⁺, 0≤x≤1) und GdTbYAG:Ce ((GdₓTb_{y}Y_{1-x-y})₃Al₅O₁₂:Ce³, 0≤x≤1, 0≤y≤1) sowie hierauf basierende Gemische erwiesen. Dabei kann Al zumindest teilweise durch Ga oder In ersetzt sein. Die genannten Leuchtstoffe sind als Beispiel und nicht als Einschränkung der allgemeinen Formeln A₃B₅X₁₂ : M zu verstehen.

Weiter als Leuchtstoff geeignet sind die Verbindungen SrS : Ce³⁺, Na, SrS : Ce³⁺, Cl, SrS : CeCl₃, CaS : Ce³⁺ und SrSe: Ce³⁺. Darüber hinaus können auch Wirtsgitter auf Sulfid- und Oxy-sulfidbasis sowie Aluminate, Borate, Erdalkalisulfide, Thiogallate, oder Orthosilikate etc. mit entsprechend im kurzwelligen Bereich anregbaren Metallzentren oder metallorganischen Leuchtstoffsysteme verwendet werden. Weiterhin können lösliche und schwer lösliche organische Farbstoffe und Leuchtstoffabmischungen eingesetzt werden.

Hinsichtlich der Korngröße der Leuchtstoffpartikel ist ein mittlerer Korndurchmesser zwischen 4 um und 10 µm, besonders bevorzugt zwischen 5 µm und 6 µm eingestellt. Die Konversionseigenschaften sind durch eine Entfernung des Staubanteils, also von Partikeln mit einem Korndurchmesser unter 2 µm aus dem Leuchtstoffpulver weiter verbessert. Mit geringer werdendem Korndurchmesser nimmt die Streuung von Strahlung an den Partikeln zu und die Konversionseffizienz ab, so daß eine Abtrennung der Leuchtstoffpartikeln mit vergleichsweise geringem Korndurchmesser vorteilhaft ist.

So haben beispielsweise Versuche gezeigt, daß eine Mahlung des Leuchtstoffs, die eine Korngröße d₅₀ wesentlich unter 5 µm erzeugt, einen Volumenanteil von bis zu 30% an Partikeln mit einer Korngröße unter einem 1 µm mit sich bringt. Partikel mit einer Größe unter einem 1 µm führen, unabhängig vom Brechzahlunterschied zur umgebenden Matrix, beispielsweise einer Kunststoffmatrix, zu einer starken Lichtstreuung und verschlechtern damit die Transmission und die Transparenz der Matrix.

Simulationsrechungen zufolge ist die Reintransmission bei einer Wellenlänge von 500 nm bei einer typischen Kunststoff-matrix mit einer Dicke von 400 µm und einer Leuchtstoffkonzentration von 3,5 Gew-% bei einer mittleren Leuchtstoffpartikelgröße von 2 um um einen Faktor der Größenordnung 1000 größer als für eine Partikelgröße von 1 µm und steigt mit zunehmender Partikelgröße weiter stark an. Für kleinere Wellenlängen wirken sich Partikelgrößen von 1 µm und darunter noch stärker aus.

Insbesondere Partikel aus dem Leuchtstoffpigment YAG : Ce zeichnen sich durch besondere Konversionseffizienz aus. Ein darauf basierender Konversionsstoff ist unter der Produktbezeichnung L175 der Fa. Osram bekannt. Mit diesem Konversionsstoff wurde ein Versuch zur Vermengung mit einer Preßmasse durchgeführt, wobei eine Preßmasse vom Typ Nitto NT-300 H10.000 mit internem Entformungsmittel zum Einsatz kam. Als Versuchsvorbereitung wurde der Konversionsstoff L175 bei 200°C für ca. 8h vorgetrocknet. Danach wurde ein Oberflächenmodifikator mit der Bezeichnung Diethylenglycolmonomethylether in Flüssigform dem vorgetrockneten Konverter beigemengt (0,1 Gew.-% bezogen auf Preßmassengewicht). Diese Mischung wurde in einem Glasgefäß luftdicht verschlossen und über Nacht stehengelassen. Direkt vor der Verarbeitung wurde der Konversionsstoff der Preßmasse des oben genannten Typs beigemengt. Die Preßmasse war vorher in einer Mühle (beispielsweise Kugelmühle) in Pulverform gemahlen worden. Das Mischungverhältnis betrug 20 Gew.-% Konversionsstoff/ DEGME-Mischung und 80 Gew.-% Nitto NT 300H-10.000. Nach dem groben Vermengen der Mischung durch Umrühren wurde das Gemisch erneut in einer Mühle (beispielsweise Kugelmühle) durchgemischt und gemahlen und somit sehr feines Pulver erzeugt.

Dann wurde mit dieser Formmasse ein Spritzgußversuch auf der Apparatur vom Typ FICO Brilliant 100 durchgeführt. Die bereits entsprechend vorgefertigten Leadframes 10 wurden vor dem Umspritzen bei 150°C vorgewärmt und bei dem Spritzguß wurden die folgenden Maschinenparameter eingestellt:
Werkzeugtemperatur: 150°C
Spritzzeit: 22,4s
Spritzdruck: 73-82 bar (u.a. abhängig von der eingestellten Materialmenge)
Aushärtezeit (curing time: 120s)

Als Ergebnis konnte eine sehr homogene, ausgehärtete Formmasse erzielt werden, die sich durch exzellente Blasen- und Lunkerfreiheit auszeichnete. Generell wurde festgestellt, daß das Vermahlen der Preßmasse zu sehr feinem Pulver vor der Vermengung bessere Ergebnisse hinsichtlich Blasen- und Lunkerfreiheit hervorbrachte als bei Verwendung eines grobkörnigeren Restmassenpulvers.

Zusätzlich kann auch noch ein Haftvermittler wie 3-Glycidoxypropyltrimethoxysilan, beispielsweise mit der Produktbezeichnung A-187 der Fa. Hüls AG, verwendet werden. Dieser Haftvermittler kann direkt nach dem Trockenprozeß dem Leuchtstoff in Konzentrationen bis 3 Gew.-% zugegeben werden und über Nacht bei Raumtemperatur mit diesem vermischt werden.

Das Verfahren ist anhand einer SMD (surface mounted design)-Bauform beschrieben worden, wobei es jedoch ebenso bei einer sogenannten Radialdiode verwirklicht werden kann.

Die Erläuterung der Erfindung anhand der beschriebenen Ausführungsbeispiele stellt selbstverständlich keine Einschränkung der Erfindung auf diese Ausführungsbeispiele dar.

## Patentansprüche

1. Oberflächenmontierbares strahlungsemittierendes Bauelement, bei dem
ein strahlungsemittierender Halbleiter-Chip (1) auf einem Leadframe (10) montiert ist,
der Leadframe (10) und der strahlungsemittierende Halbleiter-Chip (1) mit einer Formmasse (3) umhüllt sind, die derart geformt ist, dass das Bauelement eine Montagefläche (6) aufweist, die zu einer Hauptabstrahlungsrichtung (7) des Bauelements in einem ersten vorgegebenen Winkel angeordnet ist, der 0° beträgt oder zwischen 0° und 20° liegt, und dass die Formmasse (3) von dem strahlungsemittierenden Halbleiter-Chip (1) aus gesehen in Hauptabstrahlungsrichtung (7) eine gewölbte Oberfläche (15) aufweist,
der Leadframe (10) Leadframeanschlüsse (11, 12) aufweist, die aus der Formmasse (3) herausgeführt sind und Anschlussflächen aufweisen, die in einem zweiten vorgegebenen Winkel, der 90° beträgt oder zwischen 70° und 90° liegt, zu der Montagefläche (6) angeordnet sind
**dadurch gekennzeichnet, dass** der Leadframe (10) innerhalb des von der Formmasse (3) umhüllten Bereichs Durchbrüche oder seitliche Ausnehmungen (5) aufweist,
wobei in der Formmasse (3) zumindest ein Wellenlängenkonversionsstoff (4) in Form von Leuchtstoffpartikeln mit einem mittleren Korndurchmesser zwischen 4 µm und 10 µm verteilt ist und Partikel mit einem Korndurchmesser unter 2 µm entfernt sind, und wobei die Formmasse (3) Glaspartikel enthält und eine mittlere Korngröße der Glaspartikel kleiner als 50 µm ist.

2. Bauelement nach Anspruch 1, bei dem die Leadframeanschlüsse (11,12) von der Montagefläche (6) aus gesehen seitlich aus der Formmasse (3) herausgeführt sind.

3. Bauelement nach einem der vorherigen Ansprüche, bei dem sich die Leadframeanschlüsse (11,12) bis zu der durch die Montagefläche (6) festgelegten Montageebene (13) oder in die Nähe der Montageebene (13) erstrecken.

4. Bauelement nach einem der vorherigen Ansprüche, bei dem der Leadframe (10) eben ausbildet ist.

5. Bauelement nach einem der vorherigen Ansprüche, bei dem die Formmasse (3) eine zu der Montagefläche (6) parallele Deckfläche (14) aufweist.

6. Bauelement nach einem der vorherigen Ansprüche, bei dem die gewölbte Oberfläche (15) eine teilzylindrische, teilsphärische oder teilasphärische Oberfläche ist.

7. Bauelement nach einem der vorherigen Ansprüche, bei dem der strahlungsemittierende Halbleiter-Chip (1) GaN, InGaN, AlGaN, InAlGaN, ZnS, ZnSe, CdZnS oder CdZnSe enthält.

8. Bauelement nach einem der vorherigen Ansprüche, bei dem der strahlungsemittierende Halbleiter-Chip (1) sichtbares Licht oder infrarote oder ultraviolette elektromagnetische Strahlung emittiert.

9. Bauelement nach einem der vorherigen Ansprüche, bei dem die Formmasse (3) eine strahlungsdurchlässige Kunststoff-Pressmasse ist.

10. Bauelement nach einem der vorherigen Ansprüche, bei dem die Formmasse (3) auf einem Harz basiert.

11. Bauelement nach einem der vorherigen Ansprüche, bei dem die Formmasse (3) aus einem vorreagierten Epoxidharz besteht.

12. Bauelement nach dem vorherigen Anspruch, bei dem die Formmasse (3) aus Epoxynovolak oder Epoxykresolnovolak besteht.

13. Bauelement nach Anspruch 11 oder 12, bei dem das Epoxidharz mit einem Phenol- und/oder einem Anhydridhärter vorreagiert ist.

14. Bauelement nach dem vorherigen Anspruch, bei dem der Wellenlängenkonversionsstoff (4) YAG:Ce, TAG:Ce, TbYAG:Ce, GdYAG:Ce, GdTbYAG:Ce oder ein hieraus gebildetes Gemisch ist.

15. Bauelement nach einem der vorherigen Ansprüche, bei dem die Formmasse (3) einen Haftvermittler enthält.

16. Bauelement nach dem vorherigen Anspruch, bei dem der Haftvermittler 3-Glycidoxypropyltrimethoxysilan oder weitere Derivate auf Trialkoxysilan-Basis ist.

17. Bauelement nach einem der vorherigen Ansprüche, bei dem die Formmasse (3) einen Oberflächenmodifikator zur Modifikation der Oberfläche des Wellenlängenkonversionsstoffs (4) enthält.

18. Bauelement nach dem vorherigen Anspruch, bei dem der Oberflächenmodifikator Diethylenglycolmonomethylether ist.

19. Bauelement nach einem der vorherigen Ansprüche, bei dem die Formmasse (3) ein Entformungs- oder Trennmittel enthält.

20. Bauelement nach dem vorherigen Anspruch, bei dem das Entformungsmittel ein Entformungsmittel auf Wachsbasis oder eine Metallseife mit langkettigen Carbonsäuren, insbesondere Stearaten, ist.

21. Bauelement nach einem der vorherigen Ansprüche, bei dem die Formmasse (3) anorganische Füllstoffe wie TiO₂, ZrO₂, α-Al₂O₃ oder andere Metalloxide enthält, durch die der Brechungsindex der Formmasse gesteigert wird.

22. Bauelement nach einem der vorherigen Ansprüche, bei dem der Anteil der Glaspartikel an der Formmasse zwischen 0 Gew.-% und 90 Gew.-%, vorzugsweise zwischen 10 Gew-% und 50 Gew.-% liegt.

23. Bauelement nach einem der vorherigen Ansprüche, bei dem die vermengte Formmasse (3) die folgenden Bestandteile enthält:
a) Kunststoff-Preßmasse ≥ 60%
b) Wellenlängenkonversionsstoff (4) > 0% und ≤ 40%, vorzugsweise > 10% und ≤ 25%
c) Haftvermittler ≥ 0% und ≤ 3%
d) Entformungsmittel ≥ 0% und ≤ 2%
e) Oberflächenmodifikator ≥ 0% und ≤ 5%
f) Oxidationsstabilisator ≥ 0% und ≤ 5%
(z.B. auf Phosphitbasis oder auf Basis sterisch gehinderter Phenole)
g) UV-Lichtstabilisator ≥ 0% und ≤ 2%
h) Glaspartikel > 0% und ≤ 90%.

24. Bauelement nach einem der vorherigen Ansprüche, das mischfarbiges oder weißes Licht erzeugt.

## Claims

1. Surface-mountable radiation-emitting device in which a radiation-emitting semiconductor chip (1) is mounted on a leadframe (10),
the leadframe (10) and the radiation-emitting semiconductor chip (1) are surrounded by a molding material (3) which is shaped in such a way that the device has a mounting surface (6) which is arranged at a first predetermined angle which is 0° or is between 0° and 20° relative to a main emission direction (7) of the device, and that the molding material (3), viewed from the radiation-emitting semiconductor chip (1), has a curved surface (15) in the main emission direction (7), the leadframe (10) has leadframe connections (11, 12) which are led out of the molding material (3) and have connection surfaces which are arranged at a second predetermined angle which is 90° or is between 70° and 90° relative to the mounting surface (6),
**characterized in that**
the leadframe (10) has passages or lateral recesses (5) within the region surrounded by the molding material (3),
wherein at least one wavelength conversion material (4) in the form of phosphor particles having a mean particle diameter between 4 µm and 10 µm is distributed in the molding material (3) and particles having a particle. diameter of less than 2 µm are removed, and
wherein the molding material (3) contains glass particles and a mean particle size of the glass particles is less than 50 µm.

2. Device according to claim 1, in which the leadframe connections (11, 12), viewed from the mounting surface (6), are led laterally out of the molding material (3).

3. Device according to either of the preceding claims, in which the leadframe connections (11, 12) extend up to the mounting plane (13) determined by the mounting surface (6) or to the vicinity of the mounting plane (13).

4. Device according to any of the preceding claims, in which the leadframe (10) is flat.

5. Device according to any of the preceding claims, in which the molding material (3) has a top surface (14) parallel to the mounting surface (6).

6. Device according to any of the preceding claims, in which the curved surface (15) is a partly cylindrical, partly spherical or partly aspherical surface.

7. Device according to any of the preceding claims, in which the radiation-emitting semiconductor chip (1) contains GaN, InGaN, AlGaN, InAlGaN, ZnS, ZnSe, CdZnS or CdZnSe.

8. Device according to any of the preceding claims, in which the radiation-emitting semiconductor chip (1) emits visible light or infrared or ultraviolet electromagnetic radiation.

9. Device according to any of the preceding claims, in which the molding material (3) is a radiation-permeable plastics compression molding material.

10. Device according to any of the preceding claims, in which the molding material (3) is based on a resin.

11. Device according to any of the preceding claims, in which the molding material (3) consists of a prereacted epoxy resin.

12. Device according to the preceding claim, in which the molding material (3) consists of epoxy novolak or epoxy-cresol novolak.

13. Device according to claim 11 or 12, in which the epoxy resin has been prereacted with a phenol curing agent and/or with an anhydride curing agent.

14. Device according to the preceding claim, in which the wavelength conversion material (4) is YAG:Ce, TAG:Ce, TbYAG:Ce, GdYAG:Ce, GdTbYAG:Ce or a mixture formed therefrom.

15. Device according to any of the preceding claims, in which the molding material (3) contains an adhesion promoter.

16. Device according to the preceding claim, in which the adhesion promoter is 3-glycidyloxypropyltrimethoxysilane or further derivatives based on trialkoxysilane.

17. Device according to any of the preceding claims, in which the molding material (3) contains a surface modifier for modifying the surface of the wavelength conversion material (4).

18. Device according to the preceding claim, in which the surface modifier is diethylene glycol monomethyl ether.

19. Device according to any of the preceding claims, in which the molding material (3) contains a mold release agent or lubricant.

20. Device according to the preceding claim, in which the mold release agent is a wax-based mold release agent or a metal soap with long-chain carboxylic acids, in particular stearates.

21. Device according to any of the preceding claims, in which the molding material (3) contains inorganic fillers, such as TiO₂, ZrO₂, α-Al₂O₃ or other metal oxides, by means of which the refractive index of the molding material is increased.

22. Device according to any of the preceding claims, in which the proportion of glass particles in the molding material is between 0% by weight and 90% by weight, preferably between 10% by weight and 50% by weight.

23. Device according to any of the preceding claims, in which the mixed molding material (3) contains the following constituents:
a) plastics molding material ≥ 60%,
b) wavelength conversion material (4) > 0% and ≤ 40%, preferably > 10% and ≤ 25%
c) adhesion promoter ≥ 0% and ≤ 3%
d) mold release agent ≥ 0% any ≤ 2%
e) surface modifier ≥ 0% and ≤ 5%
f) antioxidant ≥ 0% and ≤ 5% (e.g. based on phosphite or based on sterically hindered phenols)
g) UV light stabilizer ≤ 0% and ≤ 2%
h) glass particles > 0% and ≤ 90%.

24. Device according to any of the preceding claims, which produces mixed-color or white light.

## Revendications

1. Composant émettant un rayonnement, pouvant être monté sur une surface, dans lequel
une puce à semi-conducteur (1) émettant un rayonnement est montée sur un support de puce « lead frame » (10), le lead frame (10) et la puce à semi-conducteur (1) émettant un rayonnement sont enrobés avec une masse moulée (3) qui est moulée de telle sorte que le composant présente une surface de montage (6) qui est disposée en formant par rapport à une première direction principale de rayonnement (7) du composant un premier angle préétabli qui vaut 0° ou est compris entre 0 et 20°, et que la masse moulée (3) présente une surface convexe (15), vue de la puce à semi-conducteur (1) émettant un rayonnement, dans la direction principale de rayonnement (7),
le leadframe (10) comporte des connexions de leadframe (11, 12) qui s'étendent à l'extérieur de la masse moulée (3) et comportent des surfaces de connexion qui sont disposées en formant par rapport à la surface de montage (6) un deuxième angle préétabli qui vaut 90° ou est compris entre 70° et 90°, **caractérisé en ce que** le leadframe (10) comporte à l'intérieur de la zone enrobée par la masse moulée (3) des perforations ou des évidements latéraux (5),
dans la masse moulée (3) au moins une substance de conversion de longueur d'onde (4) étant répartie sous forme de particules de luminophore ayant un diamètre moyen de grain compris entre 4 µm et 10 µm et les particules ayant un diamètre de grain inférieur à 2 µm étant éliminées, et
la masse moulée (3) contenant des particules de verre et une taille moyenne de grain des particules de verre étant inférieure à 50 µm.

2. Composant selon la revendication 1, dans lequel les connexions de leadframe (11, 12), vues de la surface de montage (6), s'étendent latéralement à l'extérieur de la masse moulée (3).

3. Composant selon l'une quelconque des revendications précédentes, dans lequel les connexions de leadframe (11, 12) s'étendent jusqu'au plan de montage (13) déterminé par la surface de montage (6) ou au voisinage du plan de montage (13).

4. Composant selon l'une quelconque des revendications précédentes, dans lequel le leadframe (10) à une configuration plane.

5. Composant selon l'une quelconque des revendications précédentes, dans lequel la masse moulée (3) présente une surface de couverture (14) parallèle à la surface de montage (6).

6. Composant selon l'une quelconque des revendications précédentes, dans lequel la surface convexe (15) est une surface partiellement cylindrique, partiellement sphérique ou partiellement asphérique.

7. Composant selon l'une quelconque des revendications précédentes, dans lequel la puce à semi-conducteur (1) émettant un rayonnement contient du GaN, InGaN, AlGaN, InAlGaN, ZnS, ZnSe, CdZnS ou CdZnSe.

8. Composant selon l'une quelconque des revendications précédentes, dans lequel la puce à semi-conducteur (1) émettant un rayonnement émet de la lumière visible ou un rayonnement électromagnétique infrarouge ou ultraviolet.

9. Composant selon l'une quelconque des revendications précédentes, dans lequel la masse moulée (3) est une masse moulée par compression à base de matière plastique, transparente au rayonnement.

10. Composant selon l'une quelconque des revendications précédentes, dans lequel la masse moulée (3) est à base d'une résine.

11. Composant selon l'une quelconque des revendications précédentes, dans lequel la masse moulée (3) consiste en une résine époxy ayant été mise en réaction au préalable.

12. Composant selon la revendication précédente, dans lequel la masse moulée (3) consiste en époxy novolaque ou époxy novolaque-crésol.

13. Composant selon la revendication 11 ou 12, dans lequel la résine époxy a été mise en réaction au préalable avec un durcisseur phénolique et/ou un durcisseur anhydride.

14. Composant selon la revendication précédente, dans lequel la substance de conversion de longueur d'onde (4) est YAG:Ce, TAG:Ce, TbYAG:Ce, GdYAG:Ce, GdTbYAG:Ce ou un mélange formé à partir de ceux-ci.

15. Composant selon l'une quelconque des revendications précédentes, dans lequel la masse moulée (3) contient un promoteur d'adhérence.

16. Composant selon la revendication précédente, dans lequel le promoteur d'adhérence est le 3-glycidoxypropyltriméthoxysilane ou d'autres dérivés à base de trialcoxysilane.

17. Composant selon l'une quelconque des revendications précédentes, dans lequel la masse moulée (3) contient un modificateur de surface pour la modification de la surface de la substance de conversion de longueur d'onde (4).

18. Composant selon la revendication précédente, dans lequel le modificateur de surface est l'éther monométhylique de diéthylèneglycol.

19. Composant selon l'une quelconque des revendications précédentes, dans lequel la masse moulée (3) contient un agent de séparation ou de démoulage.

20. Composant selon la revendication précédente, dans lequel l'agent de démoulage est un agent de démoulage à base de cire ou un savon métallique à acides carboxyliques à longue chaîne, en particulier des stéarates.

21. Composant selon l'une quelconque des revendications précédentes, dans lequel la masse moulée (3) contient des charges inorganiques, telles que TiO₂, ZrO₂, α-Al₂O₃ ou d'autres oxydes métalliques, au moyen desquelles l'indice de réfraction de la masse moulée est augmenté.

22. Composant selon l'une quelconque des revendications précédentes, dans lequel la proportion des particules de verre dans la masse moulée est comprise entre 0 % en poids et 90 % en poids, de préférence entre 10 % en poids et 50 % en poids.

23. Composant selon l'une quelconque des revendications précédentes, dans lequel la masse moulée (3) mélangée contient les constituants suivants :
a) matière moulée à base de matière plastique ≥ 60 %
b) substance de conversion de longueur d'onde (4) > 0 % et ≤ 40 %, de préférence > 10 % etc ≤ 25 %
c) promoteur d'adhérence ≥ 0 % etc ≤ 3 %
d) agent de démoulage ≥ 0 % et ≤ 2 %
e) modificateur de surface ≥ 0 % et ≤ 5 %
f) stabilisant vis-à-vis de l'oxydation ≥ 0 % etc ≤ 5 % (par exemple à base de phosphite ou à base de phénols à empêchement stérique)
g) stabilisant vis-à-vis de la lumière Ut ≥ 0 % et ≤ 2 %
h) particules de verre > 0 % et ≤ 90 %.

24. Composant selon l'une quelconque des revendications précédentes, qui engendre de la lumière blanche ou de couleurs variées.
